# EUROPEAN PATENT APPLICATION

(11) **EP 0 537 782 A1**
(43) Date of publication of application: **21.04.1993**
(21) Application number: 92117753.1
(22) Date of filing: 16.10.1992
(51) Int. Cl.: H01L 27/118, H01L 27/06

(54) **Semicustom-made integrated circuit device with resistors over transistor array**

(30) Priority: 18.10.1991 JP 269822/91
(71) Applicant: NEC CORPORATION, Tokyo (JP)
(72) Inventor: Shimizu, Junzoh, c/o NEC Corporation, Tokyo (JP)
(74) Representative: Glawe, Delfs, Moll & Partner

(57) **Abstract**

A semicustom-made integrated circuit device comprises a bipolar transistor array (12a/ 12b/ 12c/ 12d/ 12e) on a major surface of a silicon substrate (11) and a resistor array (16d) located over the transistor array, and the resistor array is formed from a highly resistive polysilicon film previously deposited on an inter-level oxide film sub-structure (17a/ 17b) covering the transistor array so that integration density of the bipolar transistors is increased without sacrifice of quick delivery.

## Description

### FIELD OF THE INVENTION

This invention relates to an semicustom-made integrated circuit device and, more particularly, to arrangement of circuit components of the semicustom-made integrated circuit.

### DESCRIPTION OF THE RELATED ART

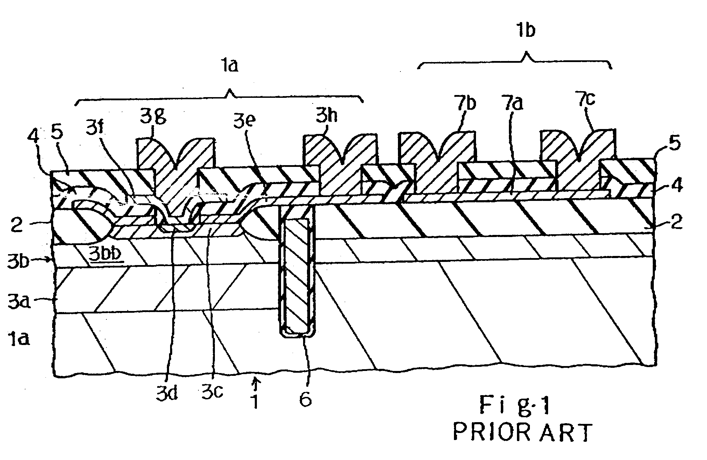

Bipolar transistors are integrated with resistors on a semiconductor chip for forming a semicustom-made integrated circuit such as, for example, a gate array or an electric circuit designed through a standard cell method, and the resistors are usually implemented by polysilicon strips. A typical example of the gate array is illustrated in Fig. 1, and the gate array is fabricated on a silicon substrate 1. The major surface of the silicon substrate 1 is divided into a bipolar area 1a and a resistor area 1b, and the bipolar area 1a and the resistor area 1b are respectively assigned to a bipolar transistor array and a resistor array. Namely, a thick field oxide film 2 is selectively grown on the major surface of the silicon substrate 1, and the thick field oxide film 2 defines active areas for the bipolar transistor array. The silicon substrate 1 comprises a lightly doped p-type silicon layer 1a, a heavily doped n-type buried layer 3a selectively formed in the lightly doped p-type silicon layer 1a, and a lightly doped n-type silicon layer 3b epitaxially grown on the lightly doped p-type silicon layer 1a and the heavily doped n-type buried layer 3a. One of the bipolar transistors of the array is shown and comprises the heavily doped n-type buried layer 3a, the lightly doped n-type collector region 3bb in the lightly doped n-type silicon layer 3b, a p-type base region 3c formed in the lightly doped n-type silicon layer 3b, and an n-type emitter region 3d also formed in the silicon layer 3b. The n-type emitter region 3d is nested in the p-type base region 3c which in turn is nested in the n-type collector region 3bb. A polysilicon strip 3e is held in contact with the p-type base region 3c, and extends on the thick field oxide film 2. An inter-level oxide film 4 covers the entire surface and, accordingly, the polysilicon strip 3e, and a contact hole is formed in the inter-level oxide film 4. Another polysilicon strip 3f is held in contact with the n-type emitter region 3d through the contact hole, and is overlain by an oxide film 5. An emitter electrode 3g of aluminum passes through a contact hole in the oxide film 5, and is held in contact with the polysilicon strip 3f. A base electrode 3h of aluminum passes through a contact hole in the oxide films 4 and 5, and is held in contact with the polysilicon strip 3e. The other bipolar transistors (not shown) are similarly constructed, and a trench 6 is provided for electrical isolation between the bipolar area 1a and the resistor area 1b.

The resistor array is implemented by low-resistive polysilicon strips one of which is illustrated in Fig. 1. Namely, the low-resistive polysilicon strip 7a is patterned on the thick field oxide film 2, and is covered with the oxide films 4 and 5. Two contact holes are formed in the oxide films 4 and 5, and expose both sides of the low-resistive polysilicon strip 7a. Aluminum electrodes 7b and 7c pass through the contact holes, respectively, and are held in contact with both sides of the low-resistive polysilicon strip 7a. Thus, the bipolar transistors and the resistors are two-dimensionally arranged over the major surface.

When a customer supplies a specification, the manufacturer, designs an electric circuit in accordance with the specification, and the bipolar transistors and the resistors are selectively connected for the electric circuit. The bipolar transistor array and the resistor array are expected to provide circuit components of various circuit arrangements, and the ratio of the bipolar transistors to the resistors is experientially determined to be 4:3. However, the actual ratio between the bipolar transistors and the resistors is variable depending upon the circuit arrangement of an electric circuit, and a large number of bipolar transistors and resistors are not utilized in the electric circuit. In fact, the maximum utility ratio is of the order of 50 per cent, and the other bipolar transistors and resistors are left without useless. Even though the bipolar transistors are miniaturized, a substantial, amount of the real estate is wasteful, and the actual integration density remains low.

If a standard cell technology is applied to the electric circuit, the bipolar transistors and the resistors are also two-dimensionally arranged as similar to the gate array, and the similar circuit function is achieved. The standard cell technology can decrease void area rather than the gate array technology, and the actual integration density is drastically enhanced. However, the designer needs to design the layout of the major surface according to the standard cell, technology, and the design work is time-consuming. The design work is three to four times longer than that of the gate array. In other words, the standard cell technology merely achieves high integration density at the sacrifice of quick delivery.

### SUMMARY OF THE INVENTION

It is therefrom an important object of the present invention to provide a semicustom-made integrated circuit which enhances the integration density without sacrifice of quick delivery.

To accomplish the object, the present invention proposes to form resistors from a highly resistive film over a transistor array fabricated on a major surface of a semiconductor substrate.

In accordance with one aspect of the present invention, there is provided an intermediate structure of a semicustom-made integrated circuit device fabricated on a semiconductor substrate, comprising: a) a transistor array having a plurality of transistors formed on a major surface of the semiconductor substrate; b) an inter-level insulating film sub-structure covering the transistor array; and c) a highly resistive film covering the inter-level insulating film sub-structure, and held in contact with predetermined nodes of the transistors through contact holes formed in the inter-level insulating film sub-structure, the highly resistive film being patterned for providing resistors selectively coupled with the transistors, the resistors being covered with an inter-level insulating film forming an inter-level insulating film structure together with the inter-level insulating film sub-structure.

In accordance with another aspect of the present invention, there is provided a semicustom-made integrated circuit device fabricated on a semiconductor substrate, comprising: a) a plurality of transistors arranged in array formed on a major surface of the semiconductor substrate; b) an inter-level insulating film sub-structure covering the transistor array; c) a plurality of resistors selectively coupled with the plurality of transistors through contact holes formed in the inter-level insulating film sub-structure, and formed from a highly resistive film extending over the inter-level insulating film sub-structure; and d) an upper inter-level insulating film covering over the plurality of resistors.

### BRIEF DESCRIPTION OF THE DRAWINGS

The features and advantages of the semicustom-made integrated circuit according to the present invention will be more clearly understood from the following description taken in conjunction with the accompanying drawings in which:
Fig. 1 is a cross sectional view showing the structure of the prior art gate array;
Fig. 2 is a cross sectional view showing the structure of a semicustom-made integrated circuit device according to the present invention;
Fig. 3 is a cross sectional view showing an intermediate structure of the semicustom-made integrated circuit device;
Fig. 4 is a circuit diagram showing the arrangement of an electric circuit fabricated from the intermediate structure of the semicustom-made integrated circuit device;
Fig. 5 is a plan view showing the layout of the semicustom-made integrated circuit device shown in Fig. 2;
Fig. 6 is a cross sectional view showing another structure of a semicustom-made integrated circuit device according to the present invention;
Fig. 7 is a circuit diagram showing an equivalent circuit of a circuitry incorporated in an emitter coupled logic circuit shown in Fig. 6;
Fig. 8 is a plan view showing the layout of the circuitry shown in Figs. 6 and 7; and
Fig. 9 is a circuit diagram showing the arrangement of a semicustom-made integrated circuit device according to the present invention.

### DESCRIPTION OF THE PREFERRED EMBODIMENTS

### First Embodiment

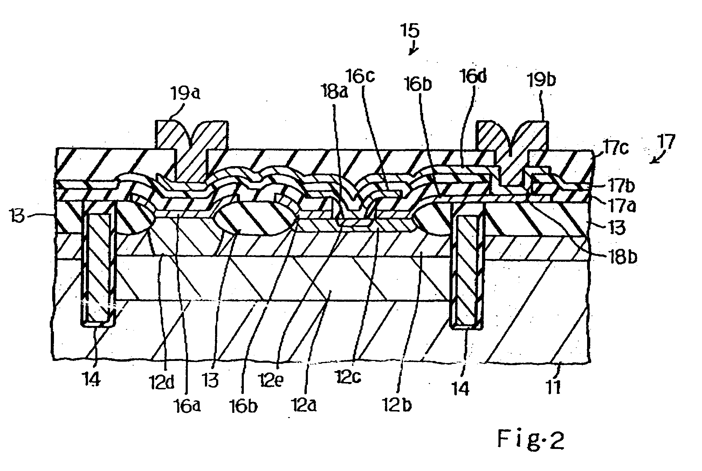

Referring to Fig. 2 of the drawings, a semicustom-made integrated circuit device embodying the present invention is fabricated on a silicon substrate, and a p-type silicon layer 11, a heavily doped n-type burried layer 12a and a lightly doped n-type silicon layer 12b form in combination the silicon substrate. The heavily doped n-type buried layer 12a is selectively formed in the p-type silicon layer 11, and the lightly doped n-type silicon layer 12b is epitaxially grown on the p-type silicon layer 11 and the heavily doped n-type buried layer 12a. The heavily doped n-type buried layer 12c and the lightly doped n-type silicon layer 12b held in contact therewith serve as a collector layer. A thick silicon oxide film 13 is selectively grown on the lightly doped n-type silicon layer 12b, and a trench-type isolation 14 vertically projects from the thick silicon oxide film 13 into the silicon substrate. The trench-type isolation 14 defines an active area for a bipolar transistor together with the thick silicon oxide film 13. A p-type base region 12c and a heavily doped n-type collector contact region 12d are formed in the lightly doped n-type silicon layer 12b, and the collector contact region 12d is merged into the heavily doped n-type burried layer 12a. An n-type emitter region 12e is nested in the p-type base region 12c, and the bipolar transistor thus arranged forms a part of a bipolar transistor array 15.

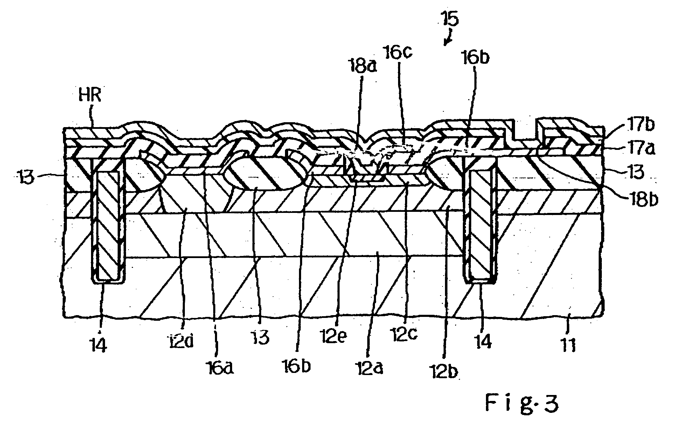

An n⁺-type doped polysilicon strip 16a and a p⁺-type doped polysilicon strip 16b are respectively held in contact with the collector contact region 12d and the base region 12c, and a first inter-level oxide film 17a covers the doped polysilicon strips 16a and 16b. A contact hole 18a is formed in the first inter-level oxide film 17a, and reach the emitter region 12e. An n⁺-type doped polysilicon strip 16c passes through the contact hole, and is held in contact with the emitter region 12e. Using a chemical vapor deposition process, a second inter-level oxide film 17b of silicon oxide or boro-phosphosilicate glass is deposited over the first inter-level oxide film 17a to thickness of 200 nanometers to 500 nanometers, and covers the doped polysilicon strip 16c. A highly resistive p-type polysilicon film HR is deposited over the second inter-level oxide film 17b to thickness of 100 nanometers to 200 nanometers. The first and second inter-level oxide films 17a and 17b as a whole constitute an inter-level insulating film sub-structure. However, the highly resistive p-type polysilicon film HR is not patterned in this stage. A contact hole 18b has been formed in the first and second inter-level oxide films 17a and 17b, and the highly resistive p-type polysilicon film is held in contact with the doped polysilicon strip 16b. Fig. 3 shows an intermediate structure of the semicustom-made integrated circuit device in this stage, and is stored by the manufacturer.

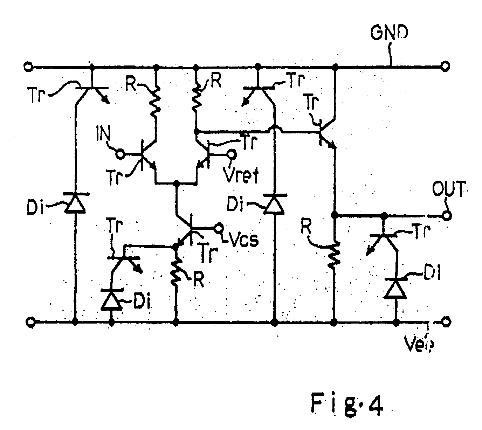

When a design specification is provided to the manufacturer, the manufacturer designs an electric circuit, and determines connections of the circuit components. The electric circuit is assumed to be arranged as shown in Fig. 4, and Tr. Di and R stand for bipolar transistors, p-n junction diodes and resistors, respectively. The electric circuit serves as a buffer circuit, and is coupled between a ground voltage line GND and a negative power voltage line Vee. When the buffer circuit is activated with a control signal Vcs, an input signal IN is compared with a reference signal Vref, and is amplified so as to produce an output signal OUT. Even if the emitter nodes of some bipolar transistors are in electrically floating state, the p-n junction diodes electrically isolate them, and has no influence on the circuit function.

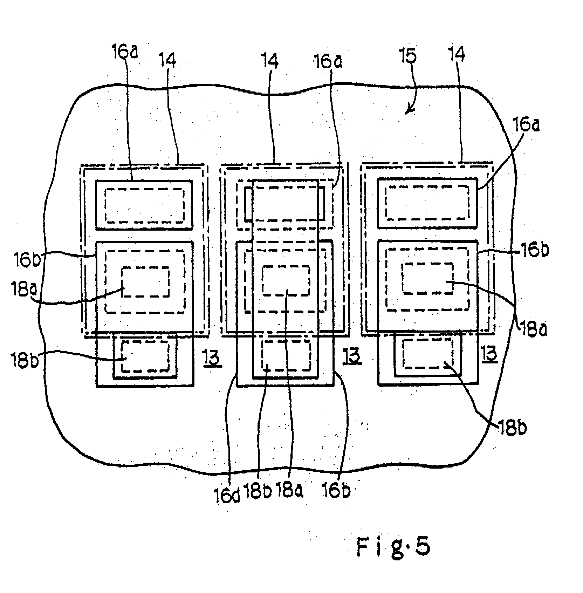

Upon completion of the electrical connections of the circuit components, the highly resistive p-type polysilicon film HR is patterned so as to selectively provide the resistors R for the bipolar transistors Tr. If the bipolar transistor shown in Fig. 3 should be coupled with a resistor R, a highly resistive p-type polysilicon strip 16d is left on the second inter-level oxide film 17b as shown in Fig. 2, and a third inter-level oxide film 17c is deposited so as to cover the highly resistive polysilicon strip 16d. Two contact holes are formed in the third inter-level oxide film 17c for exposing both sides of the highly resistive polysilicon strip 17d, and two electrodes 19a and 19b are held in contact with both sides of the highly resistive polysilicon strip 16d through the contact holes. The first, second and third inter-level oxide films 17a to 17c as a whole constitute an inter-level insulating film structure 17. However, if a bipolar transistor is not coupled with any resistor, the highly resistive polysilicon film is left around the contact hole 18b only. Fig. 5 illustrates three bipolar transistors of the array 15, and the inter-level oxide films 17a, 17b and 17c and the electrodes 19a and 19b are removed from the illustration of Fig. 5 for the sake of simplicity. The bipolar transistors on both side areas are not associated with any resistor, and the p⁺ doped polysilicon strip 16b may be coupled with either ground or negative power voltage line GND or Vee. However, the bipolar transistor in the central area is coupled with the resistor R implemented by the highly resistive polysilicon strip 16d, and forms an emitter coupled logic circuit forming part of the buffer circuit.

Thus, the bipolar transistor array 15 occupies the real estate of the silicon substrate, and the resistors R are located over the bipolar transistor array 15. A large number of bipolar transistors are formed on the major surface of the silicon substrate without enlargement of the silicon substrate, and the manufacturer has completed the bipolar transistor array 15 and the highly resistive polysilicon film HR before customer's design sheet. As a result, the integration density of the circuit components is drastically increased without sacrifice of quick delivery.

### Second Embodiment

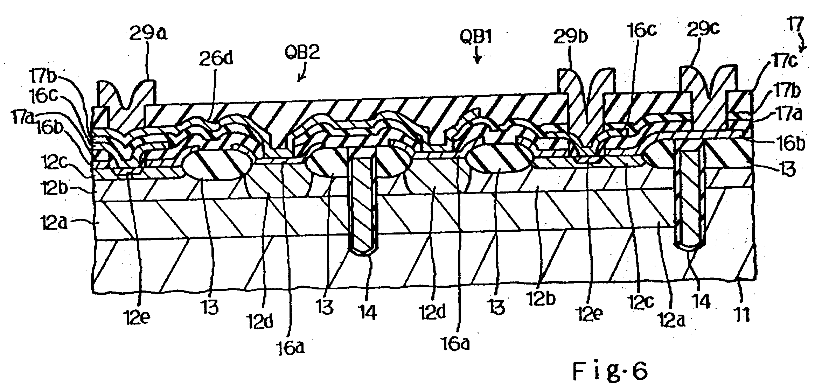

Turning to Fig. 6 of the drawings, another semicustom-made integrated circuit device embodying the present invention is fabricated on a silicon substrate. The semicustom-made integrated circuit device implementing the second embodiment is similar to the first embodiment except for connection of a highly resistive n-type polysilicon strip 26d of 100 nanometers to 200 nanometers thick, and films and regions are labeled with the same references designating corresponding films and regions of the first embodiment without detailed description. A resistor electrode 29a, an emitter electrode 29b and a base electrode 29c are respectively held in contact with the highly resistive n-type polysilicon strip 26d, the n⁺-type doped polysilicon strip 16c and the p-type doped polysilicon strip 16b, respectively.

The highly resistive n-type polysilicon strip 26d is formed from a highly resistive n-type polysilicon film for providing a resistor to the bipolar transistor, and the highly resistive n-type polysilicon film is deposited over the second inter-level oxide film 17b prior to design work for a customer. If the resistor should not be coupled with the bipolar transistor, the highly resistive n-type polysilicon strip 26d was etched away while the highly resistive n-type polysilicon film was patterned.

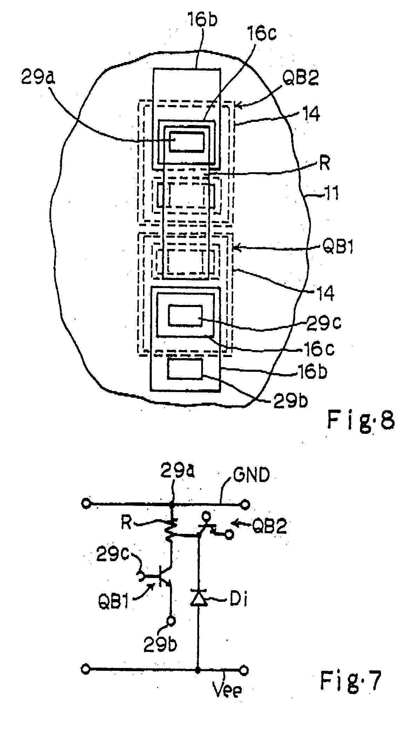

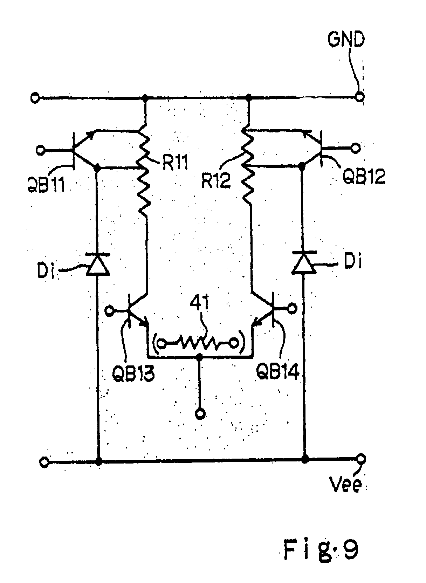

The structure implementing the second embodiment is desirable for fabricating a circuitry shown in Fig. 7. The collector nodes of two bipolar transistors QB1 and QB2 are coupled through a resistor R with a ground voltage line GND, and the electrodes 29b and 29c are respectively coupled with the base and the emitter of the bipolar transistor QB1. The ground voltage line GND is coupled with the electrode 29a, and the collector of the bipolar transistor QB2 is isolated from a negative voltage line Vee by using an p-n junction diode Di. If the circuitry shown in Fig. 7 is implemented by the prior art semicustom-made integrated circuit device, five electrodes are necessary. However, when the circuitry is implemented by the semicustom-made integrated circuit device according to the present invention, only three electrodes 29a to 29c are required. The layout of the semicustom-made integrated circuit device implementing the second embodiment is illustrated in Fig. 8.

### Third Embodiment

Turning to Fig. 9 of the drawings, another semicustom-made integrated circuit device embodying the present invention realizes an emitter coupled logic circuit, and four bipolar transistors QB11, QB12, QB13 and QB14, resistors R11 and R12 and p-n junction diodes Di are incorporated therein. A highly resistive polysilicon film 41 was coupled with the emitter nodes of the bipolar transistors QB11 to QB14 upon completion of the intermediate structure equivalent to that shown in Fig. 3. However, the highly resistive polysilicon film 41 was patterned, and appropriate metal wirings interconnect the circuit components for fabricating the emitter coupled logic circuit.

As will be appreciated from the foregoing description, the highly resistive film incorporated in the intermediate structure provides wide real estate to the transistor array, and a semicustom-made integrated circuit device is completed through selective wiring stage. As a result, the semicustom-made integrated circuit device enhances the integration density without sacrifice of the quick delivery.

Although particular embodiments of the present invention have been shown, and described, it will be obvious to those skilled in the art that various changes and modifications may be made without departing from the spirit and scope of the present invention. For example, the three-dimensional structure, i.e., the resistor array over the transistors array may effectively increase the integration density of a semicustom-made integrated circuit device designed through the standard cell method. Moreover, a highly resistive film of an intermediate structure may be held in contact with collectors as well as emitters of bipolar transistors, and is patterned after receipt of a customer's design specification.

## Claims

1. An intermediate structure of a semicustom-made integrated circuit device fabricated on a semiconductor substrate (11), comprising:
a) a transistor array having a plurality of transistors (Tr) formed on a major surface of said semiconductor substrate; and
b) an inter-level insulating film sub-structure (17a/ 17b) covering said transistor array,
characterized by
c) a highly resistive film (HR) covering said inter-level insulating film sub-structure, and held in contact with predetermined nodes (12c) of said transistors through contact holes (18b) formed in said inter-level insulating film sub-structure, said highly resistive film being patterned for providing resistors (16d/ R) selectively coupled with said transistors, said resistors being covered with an inter-level insulating film (17c) forming an inter-level insulating film structure (17) together with said inter-level insulating film sub-structure.

2. An intermediate structure as set forth in claim 1, in which said transistor array is implemented by bipolar transistors (12a/ 12b/ 12c/ 12d/ 12e).

3. An intermediate structure as set forth in claim 1, in which said highly resistive film is formed of polysilicon.

4. An intermediate structure as set forth in claim 1, in which said highly resistive film is removed from peripheral areas of predetermined contact holes selected from said contact holes so that the predetermined nodes of the associated transistors are connectable without said resistors.

5. An intermediate structure as set forth in claim 1, in which said predetermined nodes serves as base nodes (12c) of bipolar transistors, respectively.

6. A semicustom-made integrated circuit device fabricated on a semiconductor substrate (11), comprising:
a) a plurality of transistors (QB1/ QB2) arranged in array formed on a major surface of said semiconductor substrate; and
b) an inter-level insulating film sub-structure (17a/ 17b) covering said transistor array,
characterized by
c) a plurality of resistors (26d/ R; R11/ R12/ 41) selectively coupled with said plurality of transistors (QB1/ QB2; QB11/ QB12/ QB13/ QB14) through contact holes formed in said inter-level insulating film sub-structure, and formed from a highly resistive film (41) extending over said inter-level insulating film sub-structure; and
d) an upper inter-level insulating film (17c) covering over said plurality of resistors.

7. An intermediate structure as set forth in claim 6, in which said plurality of resistors are coupled with collector nodes (12d) of bipolar transistors selected from said plurality of bipolar transistors.

8. A semicustom-made integrated circuit device as set forth in claim 6, in which said plurality of resistors (R11/ R12/ 41) are coupled with emitter nodes of bipolar transistors selected from said plurality of bipolar transistors.
